# EUROPEAN PATENT SPECIFICATION

(11) **EP 3 955 328 B1**
(45) Date of publication and mention of the grant of the patent: **03.01.2024**
(21) Application number: 19923942.7
(22) Date of filing: 08.11.2019
(51) Int. Cl.: H10K 30/88

(54) **SOLAR CELL MODULE**
SOLARZELLENMODUL
MODULE DE CELLULES SOLAIRES

(30) Priority: 11.04.2019 JP 2019075491
(43) Date of publication of application: 16.02.2022
(73) Proprietor: Panasonic Intellectual Property Management Co., Ltd., Osaka-shi, Osaka 540-6207 (JP)
(72) Inventor: NISHIHARA, Takashi, Osaka (JP); YAMAMOTO, Teruaki, Osaka (JP)
(74) Representative: Grünecker Patent- und Rechtsanwälte PartG mbB
(86) International application number: PCT/JP2019/043917
(87) International publication number: WO 2020/208854

(56) References cited:
- WO-A1-2019/021616
- JP-A- 2007 531 238
- US-A1- 2018 240 848
- US-B2- 6 537 688

## Description

### Technical Field

The present disclosure relates to a solar cell module.

### Background Art

In recent years, active research and development has been conducted on perovskite solar cells. In the perovskite solar cells, a compound having a perovskite crystal structure represented by the compositional formula AMX₃ (where A is a monovalent cation, M is a divalent cation, and X is a monovalent anion) or a similar crystal structure (this compound is hereinafter referred to as a "perovskite compound") is used as a light-absorbing material. In the present description, a solar cell using the perovskite compound is referred to as a "perovskite solar cell."

NPL 1 discloses a basic structure of the perovskite solar cell. The perovskite solar cell having the basic structure includes a transparent electrode, an electron transport layer, a light-absorbing layer that uses a perovskite crystal responsible for light absorption and photo-induced charge separation (this layer is hereinafter referred to as a "perovskite layer"), a hole transport layer, and a collector electrode in this order. Specifically, the electron transport layer (n), the perovskite layer (i), and the hole transport layer (p) are stacked in this order from the transparent electrode side. This structure is called an n-i-p structure or a forward stacking structure.

NPL 2 discloses a perovskite solar cell having a structure in which a hole transport layer, a perovskite layer, and an electron transport layer are stacked in this order from a transparent electrode side. This structure is called a p-i-n structure or a reverse stacking structure.

Solar cells are devices that generate electric power when receiving sunlight, i.e., devices that utilize sunlight as an energy source. Therefore, a solar cell module including such solar cells is generally installed and used outdoors. Thus, when moisture enters the solar cell module due to rainwater and humidity, the characteristics of the solar cell module deteriorate. To prevent the deterioration of the characteristics due to moisture intrusion, PTL 1 to PTL 3, for example, propose various structures for reducing intrusion of moisture into solar cell modules.

US 2018/240848 A1 relates to a direct-conversion-type X-ray detector.

WO 2019/021616 A1 relates to an organic electroluminescent device.

### Citation List

### Patent Literature

PTL 1: Japanese Unexamined Patent Application Publication No. 2003-26455
PTL 2: Japanese Unexamined Patent Application Publication No. 2004-79823
PTL 3: Japanese Unexamined Patent Application Publication No. 2012-94608

### Non Patent Literature

NPL 1: Julian Burchcka and six others, "Nature" (UK), Vol. 499, Jul. 2013, p. 316-319
NPL 2: Wei Chen and 10 others, "SCIENCE" (US), Vol. 350, No. 6263, Nov. 2015, p. 944-948

### Summary of Invention

### Technical Problem

It is an object of the present disclosure to provide a solar cell module that can have high durability.

### Solution to Problem

A solar cell module according to the present disclosure includes:
a substrate;
a photoelectric conversion layer;
a first sealing layer located between the substrate and the photoelectric conversion layer;
a second sealing layer located between the substrate and the first sealing layer; and
an end face sealing structure that covers at least part of an edge portion of the substrate and at least part of an edge portion of the second sealing layer,
wherein the photoelectric conversion layer contains an organic material and convers light to energy,
wherein the second sealing layer has a lower water vapor permeability than the first sealing layer, and
wherein at least part of the first sealing layer is spaced apart from the end face sealing structure.

Additional benefits and advantages of the disclosed embodiments will become apparent from the present description and drawings. The benefits and/or advantages may be individually obtained by the various embodiments and features of the present description and drawings, which need not all be provided in order to obtain one or more of such benefits and/or advantages.

### Advantageous Effects of Invention

The present disclosure provides a solar cell module that can have high durability.

### Brief Description of Drawings

[Fig. 1A] Fig. 1A is a cross-sectional view schematically showing a solar cell module in an embodiment of the present disclosure.
[Fig. 1B] Fig. 1B is a plan view of the solar cell module shown in Fig. 1A.
[Fig. 2] Fig. 2 is a cross-sectional view of a photoelectric conversion layer included in the solar cell module shown in Fig. 1A.
[Fig. 3] Fig. 3 is a cross-sectional view showing a solar cell module in a modification of the embodiment in the disclosure.
[Fig. 4] Fig. 4 is a photograph of a solar cell module in Example 1 after an accelerated test.
[Fig. 5] Fig. 5 is a photograph of a solar cell module in Comparative Example 2 after the accelerated test.

### Description of Embodiments

Embodiments of the present disclosure will be described in detail with reference to the drawings.

### <Findings underlying the present disclosure>

Findings underlying the present disclosure are as follows.

A perovskite layer used in a perovskite solar cell is degraded by water, and this causes the characteristics of the perovskite layer to deteriorate. Therefore, when moisture enters a solar cell module, the conversion efficiency of the solar cells deteriorates. To prevent the reduction in the conversion efficiency of the solar cells, it is necessary to provide a sealing structure for preventing intrusion of moisture into the solar cell module.

One sealing structure for solar cell modules that is often used is a structure in which a gap between a support and a film formed of a material having a relatively low water vapor permeability is filled with an ethylene-vinyl acetate copolymer (EVA) or a polyolefin-based resin and in which edge portions of the structure are sealed with butyl rubber having a relatively low water permeability. This structure provides the waterproofness and shock resistance to the solar cell module. The support is, for example, a glass substrate with a stacked film adhering thereto when each solar cell is a thin-film solar cell. The stacked film includes the photoelectric conversion layer of the solar cell. Examples of the material having a relatively low water vapor permeability include metals.

The present inventors have conducted studies and found that, when the above sealing structure is applied to a perovskite solar cell module, the perovskite layer is degenerated and the conversion efficiency of the solar cells deteriorates. The reason for this may be as follows.

The butyl rubber sealing the edge portions is a material having a relatively low water permeability but does not completely prevent moisture from passing therethrough. Therefore, after a certain period of time, moisture passing through the butyl rubber reaches a filler formed of, for example, a polyolefin-based resin. The water content of such a filler is high. Therefore, the moisture is likely to reach the perovskite solar cells in contact with the filler.

The present inventors have conducted further studies based on the above findings and found a solar cell module having a novel sealing structure that can prevent deterioration of the solar cells in a solar cell module due to moisture, e.g., deterioration of the perovskite layer when the solar cells are perovskite solar cells.

### <Embodiments of present disclosure>

Embodiments of the present disclosure will be described in detail with reference to the drawings.

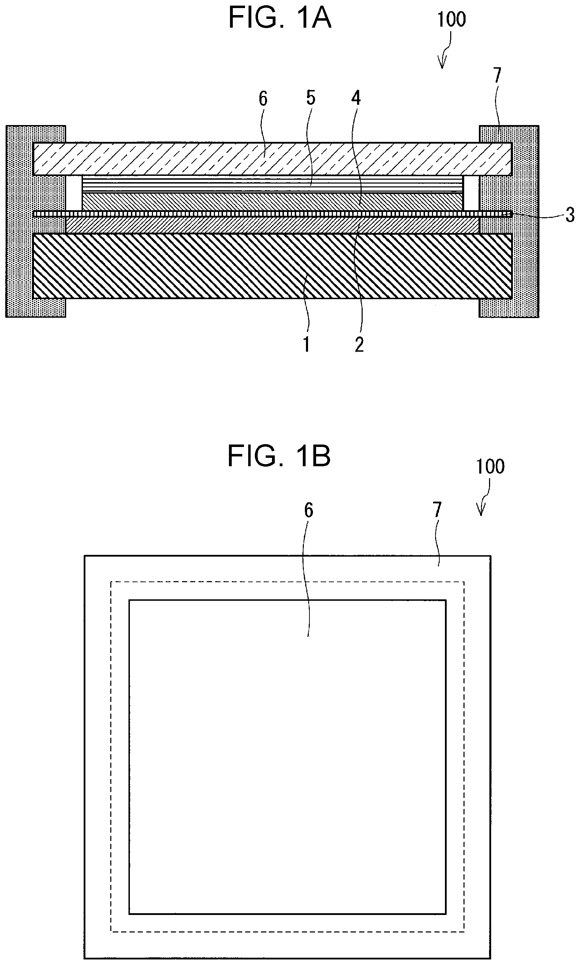

Fig. 1A is a cross-sectional view schematically showing a solar cell module 100 in an embodiment. Fig. 1B is a plan view of the solar cell module 100 shown in Fig. 1A. The plan view in Fig. 1B is a plan view when the solar cell module 100 in Fig. 1A is viewed from a light-transmitting substrate 6 side.

As shown in Fig. 1A, the solar cell module 100 includes a substrate 1, a third sealing layer 2, a second sealing layer 3, a first sealing layer 4, a photoelectric conversion layer 5, a light-transmitting substrate 6, and an end face sealing structure .7. The first sealing layer 4 is located between the substrate 1 and the photoelectric conversion layer 5. The second sealing layer 3 is located between the substrate 1 and the first sealing layer 4. The third sealing layer 2 is located between the substrate 1 and the second sealing layer 3. The third sealing layer 2 is an optional member and may not be provided. The end face sealing structure 7 covers at least part of edge portions of the substrate 1 and at least part of edge portions of the second sealing layer 3. At least part of the first sealing layer 4 is spaced apart from the end face sealing structure 7.

First, a description will be given of the photoelectric conversion layer 5 provided in order to obtain the function of the solar cell module 100.

The photoelectric conversion layer 5 contains an organic material and converts light to energy. The organic material contained in the photoelectric conversion layer 5 may be, for example, a light-absorbing material that can convert light to electric charge. Therefore, the photoelectric conversion layer 5 may contain, for example, a perovskite compound.

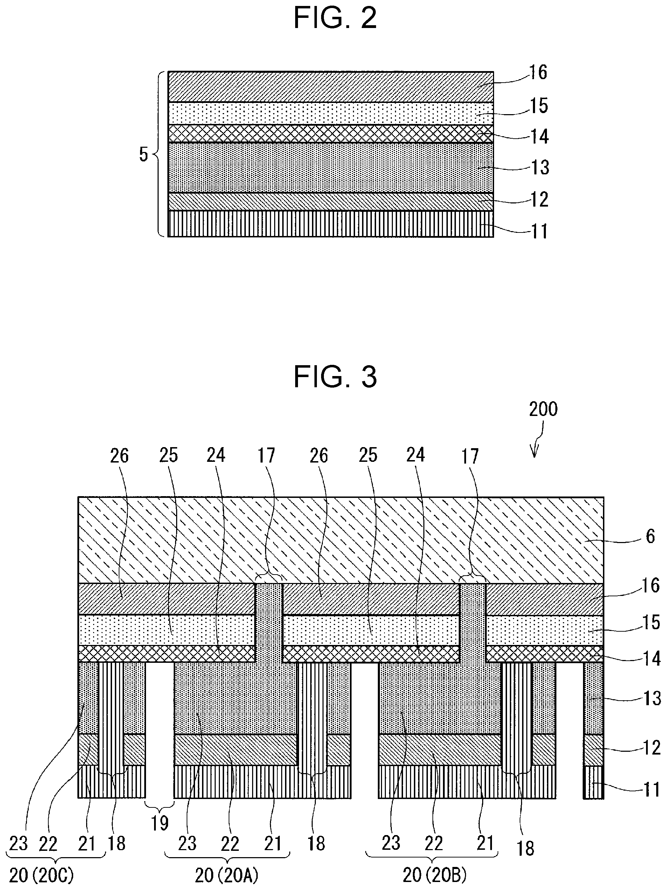

Fig. 2 is a cross-sectional view of the photoelectric conversion layer 5 included in the solar cell module 100 shown in Fig. 1A.

As shown in Fig. 2, the photoelectric conversion layer 5 includes, for example, a first electrode 16, an electron transport layer 15, a porous layer 14, a light-absorbing layer 13, a hole transport layer 12, and a second electrode 11. In the photoelectric conversion layer 5, the first electrode 16, the electron transport layer 15, the porous layer 14, the light-absorbing layer 13, the hole transport layer 12, and the second electrode 11 are stacked in this order.

The light-transmitting substrate 6 may be located on the first electrode 16 side of the photoelectric conversion layer 5 or may be located on the second electrode 11 side. Specifically, the solar cell module 100 may have a forward stacking structure in which the light-transmitting substrate 6, the first electrode 16, the electron transport layer 15, the porous layer 14, the light-absorbing layer 13, the hole transport layer 12, and the second electrode 11 are stacked in this order. Alternatively, the solar cell module 100 may have a reverse stacking structure in which the light-transmitting substrate 6, the second electrode 11, the hole transport layer 12, the light-absorbing layer 13, the electron transport layer 15, and the first electrode 16 are stacked in this order.

When the solar cell module 100 has the forward stacking structure, the first electrode 16 transmits light, and light enters the solar cell module 100 from the light-transmitting substrate 6 side. Therefore, in this case, the electron transport layer 15 and the porous layer 14 are disposed on the light incident side of the light-absorbing layer 13.

When the solar cell module 100 has the reverse stacking structure, the second electrode 11 transmits light, and light enters the solar cell module 100 from the light-transmitting substrate 6 side. Therefore, in this case, the hole transport layer 12 is disposed on the light incident side of the light-absorbing layer 13.

The light-absorbing layer 13 convers light to electric charge. The light-absorbing layer 13 contains, for example, a perovskite compound represented by the compositional formula AMX₃. Here, A is a monovalent cation, M is a divalent cation, and X is a monovalent anion.

Next, the basic operational advantages of the solar cell module 100 in the present embodiment, particularly the basic operational advantages of the photoelectric conversion layer 5, will be described.

When the solar cell module 100 is irradiated with light, the light passes through the light-transmitting substrate 6 and enters the photoelectric conversion layer 5. The light-absorbing layer 13 absorbs the light, and excited electrons and excited holes are generated. The excited electrons move toward the first electrode 16 through the porous layer 14 and the electron transport layer 15. The holes generated in the light-absorbing layer 13 move toward the second electrode 11 through the hole transport layer 12. In the photoelectric conversion layer 5, an electric current can be outputted with the first electrode 16 used as a negative electrode and the second electrode 11 used as a positive electrode.

The components of the photoelectric conversion layer 5 and the light-transmitting substrate 6 will next be described.

### [Light-transmitting substrate 6]

The light-transmitting substrate 6 physically holds the layers forming the photoelectric conversion layer 5 as films. The light-transmitting substrate 6 is, for example, a glass substrate or a plastic substrate. The plastic substrate may be a plastic film.

### [First electrode 16 and second electrode 11]

The first electrode 16 and the second electrode 11 have electrical conductivity. At least one of the first electrode 16 and the second electrode 11 transmits light. When the solar cell module 100 has the forward stacking structure, at least the first electrode 16 transmits light. When the solar cell module 100 has the reverse stacking structure, at least the second electrode 11 transmits light. In the present description, the phrase "the electrode transmits light" means that 10% or more of light having a wavelength equal to or longer than 200 nm and equal to or shorter than 2000 nm passes through the electrode.

The electrode that transmits light allows light, for example, in the visible range to the near infrared range to pass therethrough. The electrode that transmits light may be formed of at least one of metal oxides and metal nitrides that are transparent and have electric conductivity.

Examples of the metal oxide include:
(i) titanium oxide doped with at least one selected from the group consisting of lithium, magnesium, niobium, and fluorine;
(ii) gallium oxide doped with at least one selected from the group consisting of tin and silicon;
(iii) indium-tin complex oxides;
(iv) tin oxide doped with at least one selected from the group consisting of antimony and fluorine; and
(v) zinc oxide doped with at least one selected from the group consisting of boron, aluminum, gallium, and indium.

Two or more metal oxides may be combined and used as a composite.

One example of the metal nitride is gallium nitride doped with at least one selected from the group consisting of silicon and oxygen. Two or more metal nitrides may be used in combination.

A metal oxide and a metal nitride may be used in combination.

The electrode that transmits light can be formed by providing a pattern that allows light to pass therethrough using a nontransparent material. Examples of the pattern that allows light to pass therethrough include linear, wavy, and lattice-shaped patterns and a punched metal sheet-like pattern in which a large number of fine through holes are regularly or irregularly arranged. When the electrode has any of these patterns, light can pass through portions in which the electrode material is not present. Examples of the nontransparent material include platinum, gold, silver, copper, aluminum, rhodium, indium, titanium, iron, nickel, tin, zinc, and alloys containing any of the above metals. An electrically conductive carbon material may also be used.

When the photoelectric conversion layer 5 does not include the electron transport layer 15, the first electrode 16 is formed of a material having the hole blocking ability to block holes moving from the light-absorbing layer 13. In this case, the first electrode 16 is not in ohmic contact with the light-absorbing layer 13. The hole blocking ability to block the holes moving from the light-absorbing layer 13 means that only electrons generated in the light-absorbing layer 13 are allowed to pass through and the holes are not allowed to pass through. The Fermi energy level of the material having the hole blocking ability may be higher than the energy of the upper edge of the valence band of the light-absorbing layer 13. One example of such a material is aluminum. When the photoelectric conversion layer 5 includes the electron transport layer 15 disposed between the light-absorbing layer 13 and the first electrode 16, the first electrode 16 may not have the hole blocking ability to block the holes moving from the light-absorbing layer 13. Therefore, the first electrode 16 may be formed of a material that can form ohmic contact with the light-absorbing layer 13.

When the photoelectric conversion layer 5 does not include the hole transport layer 12, the second electrode 11 is formed of a material having the electron blocking ability to block electrons moving from the light-absorbing layer 13. In this case, the second electrode 11 is not in ohmic contact with the light-absorbing layer 13. The electron blocking ability to block the electrons moving from the light-absorbing layer 13 means that only holes generated in the light-absorbing layer 13 are allowed to pass through and the electrons are not allowed to pass through. The Fermi energy level of the material having the electron blocking ability is lower than the energy level of the lower edge of the conduction band of the light-absorbing layer 13. The Fermi energy level of the material having the electron blocking ability may be lower than the Fermi energy level of the light-absorbing layer 13. Specifically, the second electrode 11 may be formed of platinum, gold or a carbon material such as graphene. These materials have the electron blocking ability but cannot transmit light. Therefore, when any of these materials is used to form the light-transmitting second electrode 11, the second electrode 11 formed has a light-transmitting pattern as described above. When the photoelectric conversion layer 5 includes the hole transport layer 12 between the light-absorbing layer 13 and the second electrode 11, the second electrode 11 may not have the electron blocking ability to block electrons moving from the light-absorbing layer 13. Therefore, the second electrode 11 may be formed of a material that can form ohmic contact with the light-absorbing layer 13.

The light transmittance of the light-transmitting electrode may be equal to or higher than 50% or may be equal to or higher than 80%. The wavelength of light passing through the electrode depends on the absorption wavelength of the light-absorbing layer 13. The thickness of the first electrode 16 and the thickness of the second electrode 11 are, for example, equal to or larger than 1 nm and equal to or less than 1000 nm.

### [Electron transport layer 15]

The electron transport layer 15 contains a semiconductor. The electron transport layer 15 may be a semiconductor having a band gap equal to or larger than 3.0 eV. The electron transport layer 15 formed of a semiconductor having a band gap equal to or larger than 3.0 eV allows visible light and infrared light to pass therethrough and reach the light-absorbing layer 13. Examples of such a semiconductor include organic n-type semiconductors and inorganic n-type semiconductors.

Examples of the organic n-type semiconductors include imide compounds, quinone compounds, fullerenes, and fullerene derivatives. Examples of the inorganic n-type semiconductors include metal oxides, metal nitrides, and perovskite oxides. Examples of the metal oxides include oxides of Cd, Zn, In, Pb, Mo, W, Sb, Bi, Cu, Hg, Ti, Ag, Mn, Fe, V, Sn, Zr, Sr, Ga, Si, and Cr. Specific examples include TiO₂. Examples of the perovskite oxides include SrTiOs and CaTiOs.

The electron transport layer 15 may contain a material having a band gap larger than 6.0 eV. Examples of the material having a band gap larger than 6.0 eV include (i) halides of alkali metals and alkaline-earth metals such as lithium fluoride and calcium fluoride, (ii) alkali metal oxides such as magnesium oxide; and (iii) silicon dioxide. In this case, to allow the electron transport layer 15 to exhibit electron transport ability, the thickness of the electron transport layer 15 is, for example, equal to or less than 10 nm.

The electron transport layer 15 may include a plurality of layers formed of different materials.

### [Porous layer 14]

The porous layer 14 serves as a scaffold for forming the light-absorbing layer 13. The porous layer 14 does not impede light absorption by the light-absorbing layer 13 and electron migration from the light-absorbing layer 13 to the electron transport layer 15.

The porous layer 14 includes a porous body. One example of the porous body is a porous body formed of insulating or semiconductor particles connected together. Examples of the insulating particles include aluminum oxide particles and silicon oxide particles. Examples of the semiconductor particles include particles of inorganic semiconductors. Examples of the inorganic semiconductors include metal oxides (including perovskite oxides), metal sulfides, and metal chalcogenides. Examples of the metal oxides include oxides of Cd, Zn, In, Pb, Mo, W, Sb, Bi, Cu, Hg, Ti, Ag, Mn, Fe, V, Sn, Zr, Sr, Ga, Si, and Cr. Specific examples include TiO₂. Examples of the perovskite oxides include SrTiOs and CaTiO₃. Examples of the metal sulfides include CdS, ZnS, In₂S₃, SnS, PbS, Mo₂S, WS₂, Sb₂S₃, Bi₂S₃, ZnCdS₂, and Cu₂S. Examples of the metal chalcogenides include CdSe, CsSe, In₂Se₃, WSe₂, HgS, SnSe, PbSe, and CdTe. In the present description, the term "porous" means a material having pores thereinside.

The thickness of the porous layer 14 may be equal to or larger than 0.01 µm and equal to or less than 10 µm or may be equal to or larger than 0.1 µm and equal to or less than 1 µm. The porous layer 14 may have large surface roughness. Specifically, the surface roughness factor of the porous layer 14 that is given as the value of its effective area / its projected area may be equal to or more than 10 or may be equal to or more than 100. The projected area of an object is the area of the shadow of the object when the object is irradiated from the front. The effective area of an object is the actual surface area of the object. The effective area of the object can be computed from the volume of the object determined from the projected area of the object and its thickness, the specific surface area of the material forming the object, and its bulk density. The specific surface area can be measured, for example, by a nitrogen adsorption method.

The embodiment shown in Fig. 2 includes the porous layer 14. However, the photoelectric conversion layer 5 may not include the porous layer 14.

### [Light-absorbing layer 13]

The light-absorbing layer 13 contains, for example, a compound having a perovskite structure represented by the compositional formula AMX₃ as a light-absorbing material. A is a monovalent cation. Examples of A include monovalent cations such as alkali metal cations and organic cations. Specific examples of A include a methylammonium cation (CH₃NH₃⁺), a formamidinium cation (NH₂CHNH₂⁺), a cesium cation (Cs⁺), and a rubidium cation (Rb⁺).

In the compositional formula AMX₃, M is a divalent cation. M is, for example, a divalent cation of any of transition metals and group 13 to 15 metals. Specific examples of M include Pb²⁺, Ge²⁺, and Sn²⁺. In the compositional formula AMX₃, X is a monovalent anion such as a halogen anion.

The A, M, or X sites may be occupied by a plurality of types of ions. Specific examples of the compound having the perovskite structure include CH₃NH₃Pbl₃, CH₃CH₂NH₃Pbl₃, NH₂CHNH₂Pbl₃, CH₃NH₃PbBr₃, CH₃NH₃PbCl₃, CsPbl₃, CsPbBr₃, RbPbl₃, and RbPbBr₃.

The thickness of the light-absorbing layer 13 is, for example, equal to or more than 100 nm and equal to or less than 1000 nm. The thickness of the light-absorbing layer 13 may depend on the degree of light absorption by the light-absorbing layer 13. The light-absorbing layer 13 may be formed, for example, by a coating method using a solution or a co-deposition method. The light-absorbing layer 13 may partially coexist with a second electron transport layer 14.

### [Hole transport layer 12]

The hole transport layer 12 is formed of an organic material or an inorganic semiconductor. The hole transport layer 12 may include a plurality of layers formed of different materials.

Examples of the organic material include: organic materials having a tertiary amine in their skeleton such as phenylamine, triphenylamine derivatives, and poly-triallylamine (poly(bis(4-phenyl)(2,4,6-trimethylphenyl)amine: PTAA); and PEDOT (poly(3,4-ethylenedioxythiophene) compounds including a thiophene structure. No particular limitation is imposed on the molecular weight of the organic material, and the organic material may be a macromolecule. When the hole transport layer 12 is formed of the organic material, the layer thickness may be equal to or larger than 1 nm and equal to or less than 1000 nm or may be equal to or larger than 100 nm and equal to or less than 500 nm. When the layer thickness is in the above range, sufficient hole transport ability can be obtained. When the layer thickness is in the above range, a low resistance can be maintained, and the photoelectric power generation can be performed with high efficiency.

Examples of the inorganic semiconductor that can be used include p-type semiconductors such as CuO, Cu₂O, CuSCN, molybdenum oxide, and nickel oxide. When the hole transport layer 12 is formed of the inorganic semiconductor, the layer thickness may be equal to or larger than 1 nm and equal to or less than 1000 nm or may be equal to or larger than 10 nm and equal to or less than 50 nm. When the layer thickness is in the above range, sufficient hole transport ability is obtained. When the layer thickness is in the above range, a low resistance can be maintained, and the photoelectric power generation can be performed with high efficiency.

To form the hole transport layer 12, a coating method or a printing method can be used. Examples of the coating method include a doctor blade method, a bar coating method, a spray method, a dip coating method, and a spin coating method. Examples of the printing method include a screen printing method. If necessary, a mixture of a plurality of materials may be used to form the hole transport layer 12, and then the resulting hole transport layer 12 may be pressed or fired. When the material of the hole transport layer 12 is a low-molecular weight organic material or an inorganic semiconductor, the hole transport layer 12 can be formed, for example, by a vacuum vapor deposition method.

The hole transport layer 12 may contain a supporting electrolyte and a solvent. The supporting electrolyte and the solvent stabilize holes in the hole transport layer 12.

Examples of the supporting electrolyte include ammonium salts and alkali metal salts. Examples of the ammonium salts include tetrabutylammonium perchlorate, tetraethylammonium hexafluorophosphate, imidazolium salts, and pyridinium salts. Examples of alkali metal salts include lithium perchlorate and potassium tetrafluoroborate.

The solvent contained in the hole transport layer 12 may have high ionic conductivity. The solvent used may be an aqueous solvent or an organic solvent. To further stabilize the solute, the solvent may be an organic solvent. Examples of the organic solvent include heterocyclic compounds such as tert-butylpyridine, pyridine, and n-methylpyrrolidone.

The solvent contained in the hole transport layer 12 may be an ionic liquid. The ionic liquid may be used alone or as a mixture with another solvent. The ionic liquid is preferred because of their low volatility and high flame-resistance.

Examples of the ionic liquid include imidazolium compounds such as 1-ethyl-3-methylimidazolium tetracyanoborate, pyridine compounds, alicyclic amine compounds, aliphatic amine compounds, and azonium amine compounds.

In the present description, the thickness of each layer may be the average of values measured at a plurality of arbitrary points (e.g., 5 points). The thickness of each layer may be measured in a cross-sectional image obtained using an electron microscope.

The components of the photoelectric conversion layer 5 have been described using Fig. 2. The structure shown in Fig. 2 is an illustration used to explain the multilayer structure of the photoelectric conversion layer 5 so as to be easy to understand. A specific example of a more practical structure of the photoelectric conversion layer 5 will next be described.

Fig. 3 is a cross-sectional view schematically showing an integrated-type solar cell module 200. The integrated-type solar cell module 200 has a structure in which the photoelectric conversion layer 5 shown in Fig. 2 is divided into a plurality of unit cells 20 and the plurality of unit cells 20 are connected in series. Although not shown in Fig. 3, the integrated-type solar cell module 200 further includes the substrate 1, the third sealing layer 2, the second sealing layer 3, the first sealing layer 4, and the end face sealing structure 7, as does the solar cell module 100 shown in Fig. 1A. The integrated-type solar cell module 200 may not include the third sealing layer 2.

As shown in Fig. 3, the integrated-type solar cell module 200 includes the light-transmitting substrate 6, the first electrode 16, the electron transport layer 15, the porous layer 14, the light-absorbing layer 13, the hole transport layer 12, and the second electrode 11.

The first electrode 16, the electron transport layer 15, and the porous layer 14 are divided by first dividing grooves 17 into a plurality of first electrodes 26, a plurality of electron transport layers 25, and a plurality of porous layers 24, respectively. The light-absorbing layer 13 and the hole transport layer 12 are divided by second dividing grooves 18 into a plurality of light-absorbing layers 23 and a plurality of hole transport layers 22, respectively. The second electrode 11 is divided by third dividing grooves 19 into a plurality of second electrodes 21. The third dividing grooves 19 may be formed also in the light-absorbing layer 13 and the hole transport layer 12. The first dividing grooves 17, the second dividing grooves 18, and the third dividing grooves 19 may extend, for example, in a stripe shape. These grooves may be formed substantially in parallel to each other.

Each of the plurality of unit cells 20 has a layered structure in which a first electrode 26, an electron transport layer 25, a porous layer 24, a light-absorbing layer 23, a hole transport layer 22, and a second electrode 21 are stacked in this order. When the unit cells 20 are viewed in a direction normal to the light-transmitting substrate 6, each second dividing groove 18 is disposed so as to overlap a corresponding first electrode 26, a corresponding electron transport layer 25, and a corresponding porous layer 24. In each unit cell 20, the second electrode 21 of an adjacent unit cell 20 is disposed in a corresponding second dividing groove 18. In the each unit cell 20, the first electrode 26 is electrically connected to the second electrode 21 of the adjacent unit cell 20 in the corresponding second dividing groove 18. Specifically, the second dividing grooves 18 serve as cell connecting grooves.

As described above, each unit cell 20 is an independent solar cell including a corresponding electron transport layer 25, a corresponding porous layer 24, a corresponding light-absorbing layer 23, and a corresponding hole transport layer 22 that form an n-i-p junction and further including a corresponding first electrode 26 and a corresponding second electrode 21 that are used as output terminals.

The electrical connections between the plurality of unit cells 20 will be described using a unit cell 20 (a first unit cell 20A) and a second unit cell 20B and a third unit cell 20C that are adjacent to the first unit cell 20A.

The first electrode 26 of the first unit cell 20A is electrically connected to the second electrode 21 of the third unit cell 20C among the second unit cell 20B and the third unit cell 20C adjacent to the first unit cell 20A on opposite sides. The second electrode 21 of the first unit cell 20A is electrically connected to the first electrode 26 of the second unit cell 20B. The plurality of unit cells 20 are connected in series in the manner described above. In each unit cell 20 of the integrated-type solar cell module 200 having the plurality of unit cells 20 described above, the light-absorbing layer 23 formed on the porous layer 24 is in contact with the first electrode 26 and the electron transport layer 25, which are layers on the lower side of the porous layer 24, within the first dividing groove 17.

When the solar cell module 100 and the integrated-type solar cell module 200 are finally used outdoors, it is particularly necessary to prevent deterioration of the photoelectric conversion layer 5 including the light-absorbing layer 13 containing a material sensitive to moisture. It is therefore necessary to prevent intrusion of moisture into the photoelectric conversion layer 5 using the weather-resistant solar cell module 100 having the structure shown in Fig. 1A.

The substrate 1 holds the photoelectric conversion layer 5. The substrate 1 may have a thickness equal to or larger than 5 mm or may have a thickness equal to or larger than 10 mm in order to have sufficient mechanical strength. Since the solar cell module is used outdoors, an outer wall member of a building or its roof member may be used as the substrate 1. Examples of the outer wall member and the roof member include metal plates, ceramic plates, cement (e.g., mortar, concrete, and slate), bricks, tiles, and plaster. In particular, when a cement-based material such as mortar or slate among these materials is used for the substrate 1, the substrate 1 is formed of the material that allows moisture to pass therethrough and holds moisture. As described above, the substrate 1 may be formed of a material that allows moisture to pass therethrough and holds moisture. For example, the content of moisture in the substrate 1 may be equal to or more than 0.3 mg/cm³ under the conditions of a temperature of 60°C and atmospheric pressure. The substrate 1 may have a higher water vapor permeability than the first sealing layer 4. Even in this case, since the second sealing layer 3 having a lower water vapor permeability than the first sealing layer 4 is disposed between the substrate 1 and the photoelectric conversion layer 5, moisture passing through the substrate 1 is unlikely to reach the photoelectric conversion layer 5. The water vapor permeability is measured, for example, by an equal pressure method (MOCON method).

The second sealing layer 3 has a lower water vapor permeability than the first sealing layer 4. Examples of the second sealing layer 3 include metal films and resin films with metal or oxide coatings. One example of the resin film having a metal or oxide coating is a film obtained by depositing a metal film such as an Al film or an oxide film such as a SiO₂ film on a resin film such as a polyethylene (PE) or polyethylene terephthalate (PET) film. The thickness of the Al or SiO₂ coating deposited may be determined such that the water vapor permeability of the film is equal to or less than 0.1 g/m²/day under the conditions of a temperature of 40°C and a relative humidity of 90%RH. When the coating is an Al coating, its thickness is, for example, about 7 µm.

To bond the substrate 1 to the second sealing layer 3, the third sealing layer 2 may be disposed between the substrate 1 and the second sealing layer 3. To prevent cracking of the third sealing layer 2 when the substrate 1 receives an impact from the outside, the third sealing layer 2 may be in contact with at least part of the end face sealing structure 7. To bond the second sealing layer 3 to the light-transmitting substrate 6 having the photoelectric conversion layer 5 formed thereon, the first sealing layer 4 is disposed between the second sealing layer 3 and the photoelectric conversion layer 5. Examples of the materials of the third sealing layer 2 and the first sealing layer 4 include resins such as ethylene-vinyl acetate copolymer resins (EVA), polyolefin (PO) resins, and polyvinyl fluoride resins (PVF).

In the solar cell module 100, the end face sealing structure 7 is disposed around circumferential edge portions of a stack including the substrate 1, the third sealing layer 2, the second sealing layer 3, the first sealing layer 4, the photoelectric conversion layer 5, and the light-transmitting substrate 6. The end face sealing structure 7 covers at least part of edge portions of the substrate 1 and at least part of edge portions of the second sealing layer 3. The end face sealing structure 7 configured as described above prevents intrusion of moisture from the end faces of the solar cell module 100. Specifically, the edge portions of the substrate 1 are the circumferential portions of the substrate 1. Specifically, the edge portions of the second sealing layer 3 are the circumferential portions of the second sealing layer 3.

The end face sealing structure 7 may cover at least 95% of the entire edge portions of the substrate 1, i.e., the entire circumferential portions of the substrate 1, or may cover the entire circumferential portions of the substrate 1. The end face sealing structure 7 configured as described above can more reliably prevent intrusion of moisture from the end faces of the solar cell module 100.

The end face sealing structure 7 may cover at least 95% of the entire edge portions of the second sealing layer 3, i.e., the entire circumferential portions of the second sealing layer 3, or may cover the entire circumferential portions of the second sealing layer 3. The end face sealing structure 7 configured as described above can more reliably prevent intrusion of moisture from the end faces of the solar cell module 100. For example, when the substrate 1 and the third sealing layer 2 are formed of respective materials each having a high water vapor permeability, it is necessary that intrusion of moisture into the photoelectric conversion layer 5 be prevented by the second sealing layer 3 and the end face sealing structure 7. Therefore, as shown in Fig. 1A, the circumferential portions of the second sealing layer 3 may be fully covered with the end face sealing structure 7 and embedded in the end face sealing structure 7. The structure in which the circumferential portions of the second sealing layer 3 are embedded in the end face sealing structure 7 is, in other words, a structure in which the end face sealing structure 7 extends around the circumferential portions of the second sealing layer 3. The end face sealing structure 7 configured as described above can more reliably prevent intrusion of moisture from the end faces of the solar cell module 100. The materials having a high water vapor permeability are materials having a water vapor permeability equal to or more than 1 g/m²/day under the conditions of a temperature of 40°C and a relative humidity of 90%RH.

For example, as shown in Fig. 1A, the end face sealing structure 7 may be disposed so as to cover the entire end faces of the solar cell module 100 continuously with no gap.

For example, a material having a low water vapor permeability is used for the end face sealing structure 7. One example of the material of the end face sealing structure 7 is butyl rubber. The material having a low water vapor permeability is a material having a water vapor permeability equal to or less than 0.5 g/m²/day under the conditions of a temperature of 40°C and a relative humidity of 90%RH.

The above-described structure in which the end face sealing structure 7 covers at least part of the edge portions of the substrate 1 and at least part of the edge portions of the second sealing layer 3 can prevent intrusion of moisture into the solar cell module 100. However, the end face sealing structure 7 has, in addition to boundary surfaces with the substrate 1 and the second sealing layer 3, boundary surfaces with the first sealing layer 4. Therefore, when only the structure in which the end face sealing structure 7 covers at least part of the edge portions of the substrate 1 and at least part of the edge portions of the second sealing layer 3 is provided, moisture may enter the solar cell module 100 gradually during exposure to the outside environment for a long time. The resin such as EVA used for the first sealing layer 4 is a material with a high moisture content. Therefore, when moisture passing through the end face sealing structure 7 reaches the first sealing layer 4, the moisture is stored in the first sealing layer 4. The moisture stored in the first sealing layer 4 facilitates deterioration of the photoelectric conversion layer 5. To reduce the amount of moisture reaching the first sealing layer 4, at least part of the first sealing layer 4 is spaced apart from the end face sealing structure 7 as shown in Fig. 1A.

The material with a high moisture content is a material with a moisture content equal to or more than 0.3 mg/cm³ under the conditions of a temperature of 60°C and atmospheric pressure in a space assumed to be filled with air containing no moisture (i.e., dry air).

The first sealing layer 4 may be completely spaced apart from the end face sealing structure 7. In this structure, the moisture passing through the end face sealing structure 7 is unlikely to reach the first sealing layer 4, so that the deterioration of the photoelectric conversion layer 5 due to the moisture stored in the first sealing layer 4 can be more reliably prevented.

The width between the first sealing layer 4 and the end face sealing structure 7 spaced apart from each other (hereinafter referred to as the separation width between the first sealing layer and the end face sealing structure) is, for example, equal to or more than 1 mm and may be equal to or more than 5 mm. "The separation width between the first sealing layer and the end face sealing structure" is the distance from a surface of the end face sealing structure 7 that faces the first sealing layer 4 to an outer edge of the first sealing layer 4.

The photoelectric conversion layer 5 may also be spaced apart from the end face sealing structure 7, as is the first sealing layer 4. In this structure, the moisture passing through the end face sealing structure 7 is prevented from reaching the photoelectric conversion layer 5, so that the deterioration of the photoelectric conversion layer 5 due to moisture is prevented. The width between the photoelectric conversion layer 5 and the end face sealing structure 7 spaced apart from each other (hereinafter referred to as "the separation width between the photoelectric conversion layer and the end face sealing structure") may be larger than the separation width between the first sealing layer and the end face sealing structure. When the separation width between the photoelectric conversion layer and the end face sealing structure is large, the moisture passing through the end face sealing structure 7 is more reliably prevented from reaching the photoelectric conversion layer 5, so that deterioration of the photoelectric conversion layer 5 due to moisture is more reliably prevented.

Assume that the separation space is filled with air containing no moisture (i.e., dry air). Then the amount of saturated water vapor that can be present in the space under the conditions of a temperature of 60°C and atmospheric pressure is about 0.12 mg/cm³ and is smaller than the amount of moisture contained in the resin or cement (the amount is equal to or more than 0.3 mg/cm³ under the same conditions). Therefore, the first sealing layer 4 may be spaced apart from the end face sealing structure 7 with the space disposed between the first sealing layer 4 and the end face sealing structure 7. When the first sealing layer 4 is spaced apart from the end face sealing structure 7 with the space therebetween, the amount of moisture reaching the first sealing layer 4 can be further reduced.

A member having a lower water vapor permeability than the end face sealing structure 7 spaced apart from the first sealing layer 4 may be interposed between the first sealing layer 4 and the end face sealing structure 7. When the member having a lower water vapor permeability than the end face sealing structure 7 is used to space the first sealing layer 4 and the end face sealing structure 7 apart from each other, the amount of moisture reaching the first sealing layer 4 can be further reduced. The member having a lower water vapor permeability than the end face sealing structure 7 may be formed of a material that can adsorb moisture.

The separation space may have a structure that can prevent not only air containing no moisture but also moisture from flowing from the end face sealing structure 7 toward the first sealing layer 4.

### (EXAMPLES)

The present disclosure will be described in more detail with reference to Examples below.

Solar cell modules in Examples 1 to 5 and Comparative Examples 1 to 3 were produced, and the weather resistance of each of the solar cell modules was evaluated.

First, the structures of the solar cell modules in the Examples and Comparative Examples and their production method will be described.

### [Example 1]

The solar cell module in Example 1 has substantially the same structure as the solar cell module 100 shown in Figs. 1A and 1B and the photoelectric conversion layer 5 shown in Fig. 2. The materials, sizes, and thicknesses of the components in the solar cell module in Example 1 will be shown below.
Substrate 1: Mortar plate, size: 100 mm square, thickness: 6 mm, water vapor permeability: 50 g/m²/day
Third sealing layer 2: Polyolefin resin sheet, size: 90 mm square, thickness: 0.5 mm
Second sealing layer 3: Al-evaporated film (PET/Al/PET), size: 100 mm square, thickness: PET (50 µm)/Al (7 µm)/PET (50 µm), water vapor permeability: 0.1 g/m²/day
First sealing layer 4: Polyolefin resin sheet, size: 86 mm square, thickness: 0.5 mm, water vapor permeability: 1.6 g/m²/day
Photoelectric conversion layer 5: To be described later.
Light-transmitting substrate 6: Glass substrate, size: 100 mm square, thickness: 1 mm
End face sealing structure 7: Butyl rubber, width: 7 mm, the structure 7 seals the circumferential portions of the solar cell module (portions of the substrate 1, the second sealing layer 3, and the light-transmitting substrate 6 that extend 5 mm inward from their edges are embedded in the structure 7), water vapor permeability: 0.2/m²/day

The materials and thicknesses of the components of the photoelectric conversion layer 5 are shown below.
First electrode 16: Fluorine-doped SnO₂ layer (surface resistivity: 10 Ω/sq.)
Electron transport layer 15: TiO₂, thickness: 30 nm
Porous layer 14: TiO₂, thickness: 150 nm
Light-absorbing layer 13:
   (Rb_{0.03}Cs_{0.05}(CH₃NH₃)_{0.16}(CH₃(NH)₂)_{0.76})Pb(I_{0.95}Br_{0.05})₃, thickness: 350 nm
Hole transport layer 12: PTAA, thickness: 40 nm
Second electrode 11: Au, thickness: 200 nm

The method for producing the solar cell module in Example 1 is as follows.

First, an electrically conductive substrate having on its surface a transparent electrically conductive layer serving as the first electrode 16 was prepared. The electrically conductive substrate is a substrate including the light-transmitting substrate 6 and the first electrode 16 integrated together. In the present Example, the electrically conductive substrate used was an electrically conductive glass substrate having on its surface a fluorine-doped SnO₂ layer and having a thickness of 1 mm (manufactured by Nippon Sheet Glass Co., Ltd.).

Next, a TiO₂ layer having a thickness of 30 nm and used as the electron transport layer 15 was formed on the fluorine-doped SnO₂ layer serving as the first electrode 16. The TiO₂ layer was formed by a spray method using a 0.2 mol/L titanium diisopropoxide bis(acetylacetonate) solution prepared by diluting a 2-propanol solution of titanium diisopropoxide bis(acetylacetonate) (75 wt%, manufactured by Sigma-Aldrich) 10-fold with 2-propanol. The temperature of the substrate during spraying of the solution was 400°C. The electron transport layer 15 was thereby formed.

Next, a porous TiO₂ layer having a thickness of about 150 nm and used as the porous layer 14 was formed on the TiO₂ layer serving as the electron transport layer 15. Specifically, 1.5 g of a TiO₂ paste containing TiO₂ nanoparticles having a particle diameter of about 30 nm (30NR-D manufactured by Greatcell Solar) was suspended in 10 mL of ethanol to prepare a solution. This solution was applied to the TiO₂ layer using a spin coating method. The number of revolutions during the spin coating was set such that the porous layer 14 had a thickness of about 150 nm. Then heat treatment was performed on a hot plate at 85°C, and additional heat treatment was performed at 500°C in an electric furnace. The porous layer 14 was thereby formed.

Next, a (Rb_{0.03}Cs_{0.05}(CH₃NH₃)_{0.16}(CH₃(NH)₂)_{0.76})Pb(I_{0.95}Br_{0.05})₃ layer used as the light-absorbing layer 13 was formed on the porous TiO₂ layer serving as the porous layer 14. Specifically, first, a perovskite solution was prepared. The perovskite solution contained 1.26 mol/L of a mixture of lead iodide (Pbl₂ manufactured by TOKYO CHEMICAL INDUSTRY Co., Ltd.) and lead bromide (PbBr₂ manufactured by TOKYO CHEMICAL INDUSTRY Co., Ltd.) (Pbl₂:PbBr₂ = 95:5 (molar ratio)) and further contained 1.2 mol/L of a mixture of rubidium iodide (Rbl manufactured by Sigma-Aldrich), cesium iodide (Csl manufactured by Sigma-Aldrich), methylammonium Iodide (CH₃NH₃I manufactured by TOKYO CHEMICAL INDUSTRY Co., Ltd.), and formamidinium Iodide (CH₃(NH)₂I manufactured by TOKYO CHEMICAL INDUSTRY Co., Ltd.) (RbI:CsI:CH₃NH₃I:CH₃(NH)₂I = 3:5:16:76 (molar ratio)). The solvent in the perovskite solution was a solvent mixture prepared by mixing N,N-dimethylformamide (DMF) and dimethyl sulfoxide (DMSO) at a volume ratio of 4:1. Next, a spin coating method was used to apply the perovskite solution to the light-transmitting substrate 6 having the porous TiO₂ layer formed thereon. Then heat treatment was performed on a hot plate at 120°C to thereby obtain the light-absorbing layer 13. The number of revolutions during the spin coating was set such that the light-absorbing layer 13 had a thickness of about 350 nm. To facilitate crystallization of the light-absorbing layer 13 during the heat treatment, toluene was added dropwise to the rotating light-transmitting substrate 6 40 seconds after the start of the spin coating.

Next, a PTAA layer having a thickness of about 40 nm and used as the hole transport layer 12 was formed on the (Rb_{0.03}Cs_{0.05}(CH₃NH₃)_{0.16}(CH₃(NH)₂)_{0.76})Pb(I_{0.95}Br_{0.05})₃ layer serving as the light-absorbing layer 13. The PTAA layer was formed by a spin coating method using a solution prepared by adding 60 µL of 4-tert-butylpyridine (manufactured by Sigma-Aldrich) and 48 µL of a solution prepared by dissolving lithium bis(trifluoromethanesulfonyl)imide (Li-TFSI manufactured by TOKYO CHEMICAL INDUSTRY Co., Ltd.) in acetonitrile at a concentration of 1.8 mol/L to a solution prepared by dissolving 100 mg of PTAA (manufactured by Sigma-Aldrich) in 10 mL of toluene.

Next, a Au layer having a thickness of about 200 nm and used as the second electrode 11 was formed on the PTAA layer serving as the hole transport layer by resistive heating vapor deposition.

The photoelectric conversion layer 5 formed as described above on the light-transmitting substrate 6 was cut such that its circumferential portions having a width of 7 mm were removed. The size of the photoelectric conversion layer 5 formed on the light-transmitting substrate 6 having a size of 100 mm square was 86 mm square. To evaluate the solar cell performance of the photoelectric conversion layer 5, copper ribbons with a width of 3 mm and a thickness of 0.1 mm were bonded to the first electrode 16 and the second electrode 11 so that the electrodes could be drawn out from a sealing portion of the solar cell module 100.

Next, the first sealing layer 4, the second sealing layer 3, the third sealing layer 2, and the substrate 1 were sequentially stacked on the light-transmitting substrate 6 having the photoelectric conversion layer 5 formed thereon. The first sealing layer 4 was a polyolefin resin sheet having a size of 86 mm square and a thickness of 0.5 mm. The second sealing layer 3 was an Al-evaporated film (PET/Al/PET) having a size of 100 mm square and a total thickness of 107 µm. The third sealing layer 2 was a polyolefin resin sheet having a size of 90 mm square and a thickness of 0.5 mm. The substrate 1 was a mortar plate having a size of 100 mm square and a thickness of 6 mm. A butyl rubber sheet having a width of 7 mm and a thickness of 0.5 mm was disposed between the light-transmitting substrate 6 and the second sealing layer 3 so as to be inserted 5 mm into their circumferential portions, and another butyl rubber sheet having a width of 7 mm and a thickness of 0.5 mm was disposed between the second sealing layer 3 and the substrate 1 so as to be inserted 5 mm into their circumferential portions. In this case, butyl rubber sheets having a thickness of 0.2 mm were disposed on the upper and lower sides of each of the copper ribbons provided for drawing out the electrodes such that the total thickness of the copper ribbon and the butyl rubber sheets matched the thickness of the butyl rubber sheet with a thickness of 0.5 mm. Then a vacuum laminating apparatus was used to crosslink and cure the polyolefin resin sheets at 150°C. Finally, semi-molten butyl rubber heated to about 200°C was applied so as to be integrated with the butyl rubber sheets protruding from the circumferential portions of the light-transmitting substrate 6, the second sealing layer 3, and the substrate 1, and an aluminum-made frame was fitted to thereby obtain a solar cell module in Examples 1 having the shape shown in Fig. 1A.

The entire process for producing the solar cell module in Example 1 was performed in a dry room with a dew point equal to or lower than -40°C.

### [Example 2]

A solar cell module in Example 2 was produced using the same procedure as in Example 1 except that the cutting width of the circumferential portions of the photoelectric conversion layer 5 was changed to 6 mm so that the photoelectric conversion layer 5 formed on the light-transmitting substrate 6 having a size of 100 mm square had a size of 88 mm square.

### [Example 3]

A solar cell module in Example 3 was produced using the same procedure as in Example 1 except that the cutting width of the circumferential portions of the photoelectric conversion layer 5 was changed to 5 mm so that the photoelectric conversion layer 5 formed on the light-transmitting substrate 6 having a size of 100 mm square had a size of 90 mm square.

### [Example 4]

A solar cell module in Example 4 was produced using the same procedure as in Example 1 except that the cutting width of the circumferential portions of the photoelectric conversion layer 5 was changed to 4 mm so that the photoelectric conversion layer 5 formed on the light-transmitting substrate 6 having a size of 100 mm square had a size of 92 mm square.

### [Example 5]

A solar cell module in Example 5 was produced using the same procedure as in Example 1 except that the size of the first sealing layer 4 was changed to 88 mm square.

### [Comparative Example 1]

A solar cell module in Comparative Example 1 was produced using the same procedure as in Example 1 except that the size of the first sealing layer 4 was changed to 90 mm square.

### [Comparative Example 2]

A solar cell module in Comparative Example 2 was produced using the same procedure as in Example 1 except that the size of the first sealing layer 4 was changed to 90 mm square and that the cutting width of the circumferential portions of the photoelectric conversion layer 5 was changed to 5 mm so that the photoelectric conversion layer 5 formed on the light-transmitting substrate 6 having a size of 100 mm square had a size of 90 mm square.

### [Comparative Example 3]

A solar cell module in Comparative Example 3 was produced using the same procedure as in Example 1 except that the size of the second sealing layer 3 was changed to 90 mm square.

### [Evaluation of solar cells]

First, the photoelectric conversion characteristics of each of the solar cells in Examples 1 to 5 and Comparative Examples 1 to 3 were evaluated immediately after the production of the solar cell module.

First, a solar simulator (manufactured by SERIC LTD.) was used to irradiate the solar cell module with light having an illuminance of 100 mW/cm² to measure current-voltage characteristics. The current-voltage characteristics after stabilization were used to determine the open voltage (V) of the solar cell, its short circuit current density (mA/cm²), its fill factor, and its conversion efficiency (%).

Then the solar cell module was placed in a thermo-hygrostat at a temperature of 85°C and a relative humidity of 85% (85%RH) to perform an accelerated test. After a lapse of 1000 hours, the solar cell module was removed, and the photoelectric conversion characteristics after the accelerated test were evaluated using the method described above.

Moreover, the optical reflectance of the solar cell module was measured from the light-transmitting substrate 6 side using a spectrophotometer before and after the accelerated test. At the same time, whether or not a deteriorated portion was present was visually checked.

The results of the evaluation of the retention rate of the photoelectric conversion characteristics, the rate of change in optical reflectance, and the presence of a deteriorated portion in each of Examples 1 to 5 and Comparative Examples 1 to 3 are shown in Table 1. The retention rate of the photoelectric conversion characteristics is the retention rate of the conversion efficiency after the acceleration at 85°C and 85%RH for 1000 hours relative to the conversion efficiency in the photoelectric conversion characteristics immediately after the production of the solar cell module. The rate of change in optical reflectance is the rate of change in the optical reflectance after the acceleration at 85°C and 85%RH for 1000 hours relative to the optical reflectance immediately after the production of the solar cell module. In Table 1, the degree of coverage of the second sealing layer 3 with the end face sealing structure 7 (i.e., "the coverage degree") is represented as "Penetration depth of end face sealing structure 7 with respect to edge of second sealing layer 3." Specifically, the coverage degree is represented as the length of the end face sealing structure 7 penetrating from each edge portion of the second sealing layer 3 into the second sealing layer 3.

**[Table 1]**

| | Size of light-transmitting substrate 6 | Size of photoelectric conversion layer 5 | Size of first sealing layer 4 | Size of second sealing layer 3 | Penetration depth of end face sealing structure 7 with respect to edge of second sealing layer 3 | Retention rate of photoelectric conversion characteristics | Rate of change in optical reflectance | Deteriorated portion |
|---|---|---|---|---|---|---|---|---|
| Example 1 | 100 mm square | 86 mm square | 86 mm square | 100 mm square | 5 mm | 96% | 1% | No |
| Example 2 | 100 mm square | 88 mm square | 86 mm square | 100 mm square | 5 mm | 92% | 2% | No |
| Example 3 | 100 mm square | 90 mm square | 86 mm square | 100 mm square | 5 mm | 91% | 4% | No |
| Example 4 | 100 mm square | 92 mm square | 86 mm square | 100 mm square | 5 mm | 88% | 5% | No |
| Example 5 | 100 mm square | 86 mm square | 88 mm square | 100 mm square | 5 mm | 95% | 1% | No |
| Comparative Example 1 | 100 mm square | 86 mm square | 90 mm square | 100 mm square | 5 mm | 79% | 9% | No |
| Comparative Example 2 | 100 mm square | 90 mm square | 90 mm square | 100 mm square | 5 mm | 75% | 15% | Yes |
| Comparative Example 3 | 100 mm square | 86 mm square | 86 mm square | 90 mm square | 0 mm | 50% | 30% | Yes |

As shown in Table 1, in the weather-resistant solar cell modules in Examples 1 to 5 each having a structure in which the end face sealing structure 7 is spaced apart from the first sealing layer 4 and in which the edge portions of the second sealing layer 3 are covered with the end face sealing structure 7, the retention rate of the conversion efficiency after the acceleration at 85°C and 85%RH for 1000 hours was high, i.e., equal to or more than 88%. Moreover, in the weather-resistant solar cell modules in Examples 1 to 5, the rate of change in optical reflectance was small, i.e., equal to or less than 5%. However, in the solar cell modules in Comparative Examples 1 and 2 each having a structure in which the end face sealing structure 7 is not spaced apart from the first sealing layer 4, although the rate of change in the optical reflectance was relatively small, the retention rate of the conversion efficiency was found to be poor, i.e., less than 80%. In Comparative Example 3 having a structure in which the second sealing layer 3 is not covered with the end face sealing structure 7, the retention rate of the conversion efficiency was found to be relatively poor, i.e., 50%, and the rate of change in the optical reflectance was found to be equal to or more than 20%.

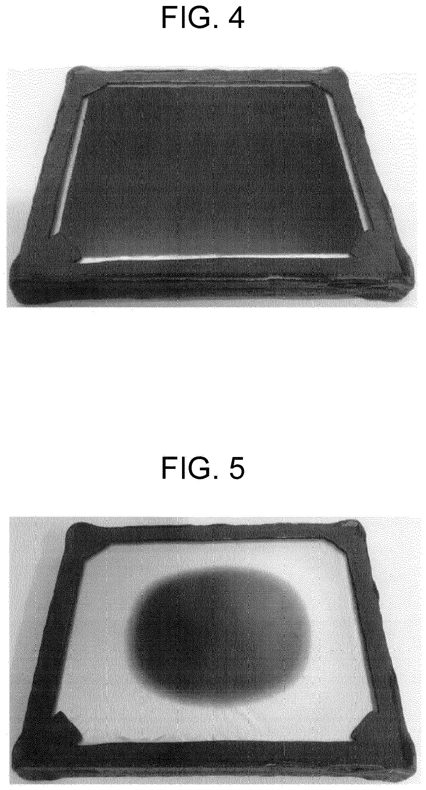

As for the presence of a deteriorated portion, no deteriorated portion was visually observed in the solar cell modules in Examples 1 to 5. However, in the solar cell modules in Comparative Examples 2 and 3, a deteriorated portion was visually observed. When a portion whose color had changed from black to yellow was found by visual inspection, this observed portion was judged to be a deteriorated portion. Fig. 4 is a photograph of the solar cell module in Example 1 after the accelerated test. Fig. 5 is a photograph of the solar cell module in Comparative Example 2 after the accelerated test. The photoelectric conversion layer 5 in the solar cell module in Example 1 was not discolored even after the accelerated test and remained black, which is the original color before the accelerated test. However, in the solar cell module in Comparative Example 2, the color of the peripheral portion of the photoelectric conversion layer 5 changed to yellow. Specifically, in the solar cell module in Comparative Example 2, the first sealing layer 4 was not spaced apart from the end face sealing structure 7. It is therefore inferred that moisture passing through the end face sealing structure 7 reached the first sealing layer 4 and the moisture caused the deterioration of the light-absorbing layer 13 in the photoelectric conversion layer 5.

As can be seen from the above results, in the solar cell modules having the structure in which the end face sealing structure 7 is spaced apart from the first sealing layer 4 and in which at least part of the edge portions of the second sealing layer 3 are covered with the end face sealing structure 7, weather resistance can be improved. It was found that, with the structure in which the end face sealing structure 7 is spaced apart from the photoelectric conversion layer 5, the weather resistance can be further improved.

### Industrial Applicability

The solar cell module of the present disclosure is particularly useful, for example, as a building-integrated solar cell module installed as a wall member or a roof member of a building.

### Reference Signs List

- 1: substrate
- 2: third sealing layer
- 3: second sealing layer
- 4: first sealing layer
- 5: photoelectric conversion layer
- 6: light-transmitting substrate
- 7: end face sealing structure
- 11, 21: second electrode
- 12, 22: hole transport layer
- 13, 23: light-absorbing layer
- 14, 24: porous layer
- 15, 25: electron transport layer
- 16, 26: first electrode
- 17: first dividing groove
- 18: second dividing groove
- 19: third dividing groove
- 20: unit cell
- 20A: first unit cell
- 20B: second unit cell
- 20C: third unit cell
- 100: solar cell module
- 200: integrated-type solar cell module

## Claims

1. A solar cell module (100) comprising:
a substrate (1);
a photoelectric conversion layer (5);
a first sealing layer (4) located between the substrate (1) and the photoelectric conversion layer (5);
a second sealing layer (3) located between the substrate (1) and the first sealing layer (4);
and an end face sealing structure (7) that covers at least part of an edge portion of the substrate (1) and at least part of an edge portion of the second sealing layer (3),
wherein the photoelectric conversion layer (5) contains an organic material and convers light to energy,
wherein the second sealing layer (3) has a lower water vapor permeability than the first sealing layer (4), and
wherein at least part of the first sealing layer (4) is spaced apart from the end face sealing structure (7).

2. The solar cell module (100) according to Claim 1,
wherein the at least part of the first sealing layer (4) is spaced apart from the end face sealing structure (7) with a space interposed between the first sealing layer (4) and the end face sealing structure (7).

3. The solar cell module (100) according to Claim 1,
wherein the at least part of the first sealing layer (4) is spaced apart from the end face sealing structure (7) with a low-water vapor permeability member interposed between the first sealing layer (4) and the end face sealing structure (7), the low-water vapor permeability member having a lower water vapor permeability than the end face sealing structure (7).

4. The solar cell module (100) according to any one of Claims 1 to 3,
wherein the edge portion of the second sealing layer (3) is embedded in the end face sealing structure (7).

5. The solar cell module (100) according to any one of Claims 1 to 4,
further comprising a third sealing layer (2) that is located between the substrate (1) and the second sealing layer (3) and is in contact with at least part of the end face sealing structure (7).

6. The solar cell module (100) according to any one of Claims 1 to 5,
wherein the photoelectric conversion layer (5) is spaced apart from the end face sealing structure (7).

7. The solar cell module (100) according to any one of Claims 1 to 6,
wherein the substrate (1) has a higher water vapor permeability than the first sealing layer (4).

8. The solar cell module (100) according to any one of Claims 1 to 7,
wherein the content of water in the substrate is equal to or more than 0.3 mg/cm3 under conditions of a temperature of 60°C and atmospheric pressure.

9. The solar cell module (100) according to any one of Claims 1 to 8,
wherein the photoelectric conversion layer (5) contains a perovskite compound.

## Patentansprüche

1. Solarzellen-Modul (100), das umfasst:
ein Substrat (1);
eine photoelektrische Umwandlungsschicht (5);
eine erste Dichtungsschicht (4), die sich zwischen dem Substrat (1) und der photoelektrischen Umwandlungsschicht (5) befindet;
eine zweite Dichtungsschicht (3), die sich zwischen dem Substrat (1) und der ersten Dichtungsschicht (4) befindet;
sowie
eine Endflächen-Dichtungsstruktur (7), die wenigstens einen Teil eines Randabschnitts des Substrats (1) und wenigstens einen Teil eines Randabschnitts der zweiten Dichtungsschicht (3) abdeckt,
wobei die photoelektrische Umwandlungsschicht (5) ein organisches Material enthält und Licht in Energie umwandelt,
die zweite Dichtungsschicht (3) eine niedrigere Wasserdampfdurchlässigkeit hat als die erste Dichtungsschicht (4), und
wenigstens ein Teil der ersten Dichtungsschicht (4) von der Endflächen-Dichtungsstruktur (7) beabstandet ist.

2. Solarzellen-Modul (100) nach Anspruch 1,
wobei wenigstens ein Teil der ersten Dichtungsschicht (4) von der Endflächen-Dichtungsstruktur (7) mit einem Zwischenraum beabstandet ist, der zwischen der ersten Dichtungsschicht (4) und der Endflächen-Dichtungsstruktur (7) angeordnet ist.

3. Solarzellen-Modul (100) nach Anspruch 1,
wobei der wenigstens eine Teil der ersten Dichtungsschicht (4) von der Endflächen-Dichtungsstruktur (7) mit einem Element mit niedriger Wasserdampfdurchlässigkeit beabstandet ist, das zwischen der ersten Dichtungsschicht (4) und der Endflächen-Dichtungsstruktur (7) angeordnet ist, wobei das Element mit niedriger Wasserdampfdurchlässigkeit eine niedrigere Wasserdampfdurchlässigkeit hat als die Endflächen-Dichtungsstruktur (7).

4. Solarzellen-Modul (100) nach einem der Ansprüche 1 bis 3,
wobei der Randabschnitt der zweiten Dichtungsschicht (3) in die Endflächen-Dichtungsstruktur (7) eingebettet ist.

5. Solarzellen-Modul (100) nach einem der Ansprüche 1 bis 4,
das des Weiteren eine dritte Dichtungsschicht (2) umfasst, die sich zwischen dem Substrat (1) und der zweiten Dichtungsschicht (3) befindet und mit wenigstens einem Teil der Endflächen-Dichtungsstruktur (7) in Kontakt ist.

6. Solarzellen-Modul (100) nach einem der Ansprüche 1 bis 5,
wobei die photoelektrische Umwandlungsschicht (5) von der Endflächen-Dichtungsstruktur (7) beabstandet ist.

7. Solarzellen-Modul (100) nach einem der Ansprüche 1 bis 6,
wobei das Substrat (1) eine höhere Wasserdampfdurchlässigkeit hat als die erste Dichtungsschicht (4).

8. Solarzellen-Modul (100) nach einem der Ansprüche 1 bis 7,
wobei der Wassergehalt in dem Substrat bei einer Temperatur von 60 °C und atmosphärischem Druck 0,3 mg/cm³ oder mehr beträgt.

9. Solarzellen-Modul (100) nach einem der Ansprüche 1 bis 8,
wobei die photoelektrische Umwandlungsschicht (5) eine Perowskit-Verbindung enthält.

## Revendications

1. Module de cellules solaires (100) comprenant :
un substrat (1) ;
une couche de conversion photoélectrique (5) ;
une première couche d'étanchéité (4) placée entre le substrat (1) et la couche de conversion photoélectrique (5) ;
une deuxième couche d'étanchéité (3) placée entre le substrat (1) et la première couche d'étanchéité (4) ; et
une structure d'étanchéité de côté d'extrémité (7) qui couvre au moins une partie d'une partie d'arête du substrat (1) et au moins une partie d'une partie d'arête de la deuxième couche d'étanchéité (3),
dans lequel la couche de conversion photoélectrique (5) contient un matériau organique et convertit la lumière en énergie,
dans lequel la deuxième couche d'étanchéité (3) présente une perméabilité à la vapeur d'eau inférieure à la première couche d'étanchéité (4), et
dans lequel au moins une partie de la première couche d'étanchéité (4) est éloignée par espacement de la structure d'étanchéité de côté d'extrémité (7).

2. Le module de cellules solaires (100) selon la revendication 1,
dans lequel l'au moins une partie de la première couche d'étanchéité (4) est éloignée par espacement de la structure d'étanchéité de côté d'extrémité (7) par un espace interposé entre la première couche d'étanchéité (4) et la structure d'étanchéité de côté d'extrémité (7) .

3. Le module de cellules solaires (100) selon la revendication 1,
dans lequel l'au moins une partie de la première couche d'étanchéité (4) est éloignée par espacement de la structure d'étanchéité de côté d'extrémité (7) par un élément de faible perméabilité à la vapeur d'eau interposé entre la première couche d'étanchéité (4) et la structure d'étanchéité de côté d'extrémité (7), l'élément de faible perméabilité à la vapeur d'eau présentant une perméabilité à la vapeur d'eau inférieure à la structure d'étanchéité de côté d'extrémité (7).

4. Le module de cellules solaires (100) selon l'une quelconque des revendications 1 à 3,
dans lequel la partie d'arête de la deuxième couche d'étanchéité (3) est intégrée à la structure d'étanchéité de côté d'extrémité (7).

5. le module de cellules solaires (100) selon l'une quelconque des revendications 1 à 4,
comprenant en outre une troisième couche d'étanchéité (2) qui est placée entre le substrat (1) et la deuxième couche d'étanchéité (3) et est en contact avec au moins une partie de la structure d'étanchéité de côté d'extrémité (7).

6. Le module de cellules solaires (100) selon l'une quelconque des revendications 1 à 5,
dans lequel la couche de conversion photoélectrique (5) est éloignée par espacement de la structure d'étanchéité de côté d'extrémité (7).

7. Le module de cellules solaires (100) selon l'une quelconque des revendications 1 à 6,
dans lequel le substrat (1) présente une perméabilité à la vapeur d'eau supérieure à la première couche d'étanchéité (4).

8. Le module de cellules solaires (100) selon l'une quelconque des revendications 1 à 7,
dans lequel la teneur en eau dans le substrat est supérieure ou égale à 0,3 mg/cm³ dans des conditions d'une température de 60 °C et de pression atmosphérique.

9. le module de cellules solaires (100) selon l'une quelconque des revendications 1 à 8,
dans lequel la couche de conversion photoélectrique (5) contient un composé perovskite.
